# EUROPEAN PATENT APPLICATION

(11) **EP 4 708 677 A1**
(43) Date of publication of application: **11.03.2026**
(21) Application number: 24198995.3
(22) Date of filing: 06.09.2024
(51) Int. Cl.: H03F 1/22, H03F 1/26, H03F 1/56, H03F 3/193, H03F 3/195, H03F 3/26, H03F 3/45, H03F 1/34

(54) **NOISE-CANCELLATION AMPLIFIER**

(71) Applicant: NXP B.V., 5656 AG Eindhoven (NL)
(72) Inventor: Chen, Yi-Wen, Irvine, 92618 (US); Enam, Syed Khursheed, Irvine, 92618 (US)
(74) Representative: Krott, Michel

(57) **Abstract**

Described is a noise-cancellation amplifier (200), comprising a first inductor system with a first inductor (L1) and a second inductor (L2); a second inductor system with a third inductor (L3) and a fourth inductor (L4); a first transistor (T1) being coupled with the third inductor (L3); a second transistor (T2) being coupled with the fourth inductor (L4); and a third inductor system with a fifth inductor (L5) and a sixth inductor (L6), the fifth inductor (L5) being coupled with a gate of the first transistor (T1) and the sixth inductor (L6) being coupled with a gate of the second transistor (T2); wherein the first inductor system is inductively coupled with the second inductor system and the second inductor system is inductively coupled with the third inductor system. In this way, a noise cancellation effect of the noise cancellation amplifier (200) may be improved.

## Description

### TECHNICAL FIELD

The present disclosure relates to a noise-cancellation amplifier.

### BACKGROUND

Noise-cancellation amplifiers (Low-Noise Amplifiers, LNAs) are essential in various fields because they can amplify weak signals without significantly increasing noise. They play a crucial role in improving signal reception, extending the range of communication systems, and enhancing the performance of various electronic and scientific instruments.

### SUMMARY

A first aspect of the present disclosure is directed to a noise-cancellation amplifier. The described noise-cancellation amplifier comprises: (a) a first inductor system with a first inductor and a second inductor; (b) a second inductor system with a third inductor and a fourth inductor; (c) a first transistor being coupled with the third inductor; (d) a second transistor being coupled with the fourth inductor; and (e) a third inductor system with a fifth inductor and a sixth inductor. The fifth inductor is coupled with a gate of the first transistor and the sixth inductor being coupled with a gate of the second transistor. Further, the first inductor system is inductively coupled with the second inductor system and the second inductor system is inductively coupled with the third inductor system.

In this way, a use of resistors and capacitors for noise cancellation, as in conventional systems, may be avoided. Furthermore, as compared to a conventional noise-cancellation LNA the second and third inductor systems can be realized in a simple and effective manner. Hence, the described noise cancellation amplifier can be realized with a comparatively small footprint area in an easy and cost-effective manner. In this way, a layout of the LNA is simplified, and performance may be improved due to fewer components and area savings. Parasitic effects in the layout phase may be reduced due to fewer on-chip components. An iteration process in a design phase of the noise-cancellation amplifier may also be shortened.

In one or more embodiments, the third inductor is inductively coupled with the sixth inductor. This may mean that there is a so called cross-coupling between the second inductor system and the third inductor system. The described cross coupling may allow to realize the described noise-cancellation amplifier in a highly symmetrical manner. This may make the described noise-cancellation amplifier less prone to minor (unwanted) production variances.

In one or more embodiments, the fourth inductor is inductively coupled with the fifth inductor. With such an additional cross-coupling between the second inductor system and the third inductor system the symmetry of the described noise-cancellation amplifier will be further increased. Hence, the immunity against (unwanted) production variances may be further increased.

In one or more embodiments, a coupling factor between the second inductor system and the third inductor system is at least 0.7, preferably > 0.7, more preferably 0.8.

Designing the inductor systems accordingly may suitably determine the coupling factor, which yields a sufficiently strong functional relationship between the second inductor system and the third inductor system. The described comparatively large coupling factors may provide the advantage that a stable and reliable noise cancellation system can be realized even in difficult operating conditions such as e.g. in the presence of comparatively strong external radio frequency (RF) signals representing a strong electromagnetic pollution.

In one or more embodiments, the fifth inductor is connected in series with the sixth inductor, wherein an input node is formed between the fifth inductor and the sixth inductor. The described input node and in particular its location between the fifth inductor and the sixth inductor may allow to feed appropriate input signals into the noise-cancellation amplifier in a simple and reliable manner.

In one or more embodiments, the input node is configured to receive a biasing signal for the transistors. This may make it comfortable to set the operating points of the transistors.

In one or more embodiments, the third inductor is connected in series with the fourth inductor through a second connection point of the third inductor and a first connection point of the fourth inductor, wherein the first connection point of the fourth inductor and the second connection point of the third inductor are connected to ground. The described ground connection is, at least concerning its position within the noise-cancellation amplifier, a highly symmetric ground connection. This may provide the advantage that different sections of the noise-cancellation amplifier can be grounded reliably without having the risk of capturing external disturbing signals, particularly unwanted radio frequency (RF) signals.

In one or more embodiments, the first inductor and the second inductor are connected in series. This may provide the advantage that these inductors can be used as a primary coil of a balun transformer. This means that per se known balun transformer topologies can be used for realizing the described noise-cancellation amplifier.

In one or more embodiments, a first connection point of the third inductor is coupled to a source of the first transistor and a second connection point of the fourth inductor is coupled to a source of the second transistor. In this way, signals get copied from the second transistor's source to the first transistor's gate and from the first transistor's source to the second transistor's gate. This may provide a contribution to a further improvement of cancellation of transistors noise.

In one or more embodiments, the noise-cancellation amplifier further comprises a cascode device, wherein drains of the first and second transistors are coupled to the cascode device. The cascode device configuration separates the input and output functions across the first and second transistors. This separation reduces the Miller effect (a capacitance effect that limits the bandwidth), allowing for a higher gain-bandwidth product. Furthermore, enhanced linearity, lower noise figure, higher gain and increased output resistance is supported in this way, which may improve an overall voltage gain of the noise-cancellation amplifier.

In one or more embodiments, the first inductor is inductively coupled to the third inductor and the sixth inductor. Alternatively or in combination, the second inductor is inductively coupled to the fourth inductor and the fifth inductor. The described inductive couplings may help providing the noise-cancellation amplifier's high efficiency in combination with a balun transformer.

In one or more embodiments, the inductors of the first inductor system are made of a first conductive layer and the inductors of the second and third inductor systems are made of a second conductive layer. This may allow the realization of the described noise-cancellation amplifier with a cheap mass production technology such as at least one semiconductor technology, multi-layer printed circuit technology, or any other processing technology taking benefit from building up-layer sequences. In particular, using the described conductive layers may allow to realize with common processing steps the formation of a plurality of noise-cancellation amplifier on a common substrate. When manufacturing the described noise-cancellation amplifiers a high production may be achieved. Consequently, each of the described noise-cancellation amplifiers may be produced in a highly cost-effective manner.

In one or more embodiments, at least one of the first and second conductive layers is a metal layer. This may support simple and cost-effective implementation of the inductor systems of the noise-cancellation amplifier.

### BRIEF DESCRIPTION OF DRAWINGS

The above discussion/summary does not describe each embodiment or implementation of the present disclosure; the following drawings and detailed description also exemplify various embodiments. The aspects defined above and further aspects of the present disclosure are apparent from the examples of embodiments described hereinafter concerning the appended drawings, which are explained concerning the examples of embodiment. However, the disclosure is not limited to the examples of embodiment. Rather, the intention is to cover all modifications, equivalents, and alternatives falling within the scope of the disclosure, including aspects defined in the claims. In addition, the term "example," used throughout this application, is only used as an illustration and not as a limitation.

All illustrations in the drawings are only schematic and not necessarily drawn to scale. In various figures, similar or identical elements or features are provided with the same reference signs or reference signs that only differ from the corresponding reference signs in the first digit. To avoid unnecessary repetition, elements or features that have already been explained concerning a previously described embodiment are not explained again later in the description.

Various example embodiments may be more completely understood in consideration of the following detailed description in connection with the accompanying drawings.
- FIG. 1: shows a circuit diagram of a conventional noise-cancellation amplifier;
- FIG. 2: shows a noise-cancellation amplifier according to the present disclosure;
- FIG. 3: shows inductor systems of the noise-cancellation amplifier of FIG. 2; and
- FIG. 4: shows a structural drawing of conductive layers implementing the inductor systems.

### DESCRIPTION OF EMBODIMENTS

In the following description, various details are set forth to describe specific examples presented herein. However, it should be apparent to one skilled in the art that one or more other examples and/or variations of these examples may be practiced without all the specific details given below. In other instances, well-known features have not been described in detail to not obscure the examples' descriptions. For ease of illustration, the same reference signs may be used in different diagrams to refer to the same elements or additional instances of the same element. Also, although aspects and features may, in some cases, be described in individual figures, it will be appreciated that features from one figure or embodiment can be combined with features of another figure or embodiment even though the combination is not explicitly shown or described as a combination.

A low-noise amplifier (LNA) amplifies weak electric signals without significantly degrading their signal-to-noise ratio (SNR). Low-noise amplifiers are typically used in applications where the input signals are very weak and must be amplified before further processing, such as radio, satellite, and radar systems. The present disclosure proposes using cross-coupled inductors for an interconnection stage between a balun and a cascode device for noise suppression.

In this way, fewer components are required than conventional noise-cancellation low-noise amplifiers, making noise cancellation less dependent on process variations. The reduced area and more straightforward implementation help keep the noise figure low.

Complying with application-dependent noise figure requirements in basic Complementary Metal-Oxide Semiconductor (CMOS) technology LNAs may be challenging. Existing noise-canceling strategies usually significantly increase current consumption or the area required to build up a corresponding LNA. Further, sophisticated calibration routines may be required. In wireless connectivity, there is a challenge in area and power consumption savings.

A differential Common-Gate Low Noise Amplifier (CG LNA) is a specific type of LNA that employs a common-gate (CG) configuration in a differential setup. This configuration is popular in RF and microwave circuit design due to its favorable noise performance and impedance-matching characteristics.

The noise-canceling LNA architecture described hereinafter meets so-called Noise Figure requirements, which are given for each wireless communication standard. In particular, the Noise Figure requirements for Ultra-wideband (UWB) radio technology with a very low energy level for short-range, high-bandwidth communications over a large portion of the radio spectrum can be met easily and effectively.

In the context of electronics and signal processing, "noise figure" measures the noise performance of an amplifier or a radio frequency (RF) circuit. The cross-coupled inductors may eliminate bulky cross-coupled capacitors and bias resistors, which are usually used for balancing radio frequency signals, making the implementation more balanced. In more detail, eliminating such devices introduces fewer components and may reduce process variation that might otherwise introduce an imbalance. It greatly simplifies layout complexity, which results in better noise-cancelling performance.

In radio frequency (RF) circuits, a balun with a secondary coil might be used to convert between a balanced transmission line (such as a twin-lead or a balanced antenna) and an unbalanced transmission line (e.g., coaxial cable). A noise-cancellation low-noise amplifier (LNA) is designed to minimize the noise introduced during the amplification process, thereby enhancing the signal-to-noise ratio (SNR) of the received signal. This type of LNA employs specific techniques to cancel or reduce the noise, often using differential designs and feedback mechanisms.

A balun device implemented as a transformer can be used to convert single-ended signals to differential signals before they enter the low-noise amplifier. This allows for the noise benefits of differential operation even if the input signal is single-ended. A balun transformer usually consists of two coils or windings: the primary coil and the secondary coil. At the primary coil an input signal is applied, and at the secondary coil the output signal is taken. The balun's purpose is often to convert balanced and unbalanced signals or match impedance between different circuit components. In the context of a balun, the secondary coil typically refers to the winding or coil on the output side of the balun transformer.

A balun takes two conductors with equal but opposite voltages (a balanced signal) and transforms it into a single conductor signal with respect to the ground (an unbalanced signal). This is common in applications like connecting a balanced transmission line to an unbalanced load, such as an antenna to a coaxial cable.

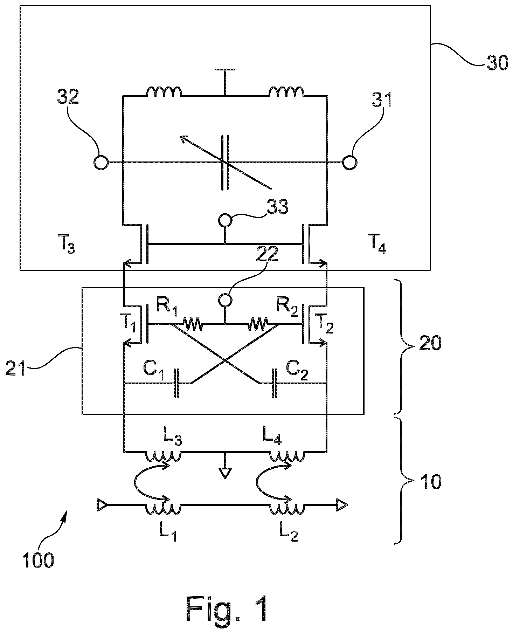

FIG. 1 is a conventional common gate noise-cancellation amplifier 100 circuit diagram. The amplifier 100 comprises a balun device 10 implemented as a transformer, which is functionally coupled to a connection stage 20. The connection stage 20 comprises a noise cancellation structure 21, comprising resistors R1 and R2 being connected in series and coupled between gates of transistors T1 and T2. A connection point of a first resistor R1 is connected to a base of the first transistor T1 and a connection point of a second resistor R2 is connected to a base of the second transistor T2. An input node 22 is used for applying a bias signal for the transistors T1, T2.

Furthermore, a balun device 10 comprises a first inductor system with a first inductor L1 and a second inductor L2 being connected in series. Furthermore, the balun device 10 comprises a second inductor system comprising a pair of series-connected inductors L3, L4, which inductor L3, L4 may thus be described as secondary inductors. Similar to the first inductor system, the second inductor system comprises a third inductor L3 and a fourth inductor L4, the third inductor L3 and the fourth inductor L4 being connected in series, wherein a connection point is connected to the ground. The common gate low-noise amplifier 100 further comprises a cascode device 30 being connected to the connection stage 20.

The noise of the transistors T1 and T2 noise may be canceled by means of the cross-coupled capacitors C1, C2, which are used to capacitively coupling signals from sources of transistors T2, T1 to gates of the transistors T1, T2, respectively. A main noise source is represented by the transistors T1, T2. An input of the low-noise amplifier 100 is represented mainly by the sources of the two transistors T1, T2. The second capacitor C2 provides an AC-coupling between the source of the first transistor T1 and the gate of the second transistor T2 (and vice versa, also through the source of second transistor T2, to the gate of the first transistor T1).

Thus, noise from the source of the first transistor T1 may be copied to the gate of the second transistor T2. As an effect, the noise at the sources of the transistors T1 and T2 is connected to the gates of said transistors T1, T2, resulting in a noise cancellation effect.

Output signals of the conventional low-noise amplifier 100 are provided at outputs 31 (positive output) and 32 (negative output) of a cascode device 30. An input node 33 is used to apply a biasing signal for the transistors T3, T4 of the cascode device 30.

To achieve a similar noise-cancelling effect in a noise-cancelling LNA, the present disclosure proposes implementing cross-coupled inductors (integrated with a balun device) instead of cross-coupled capacitors.

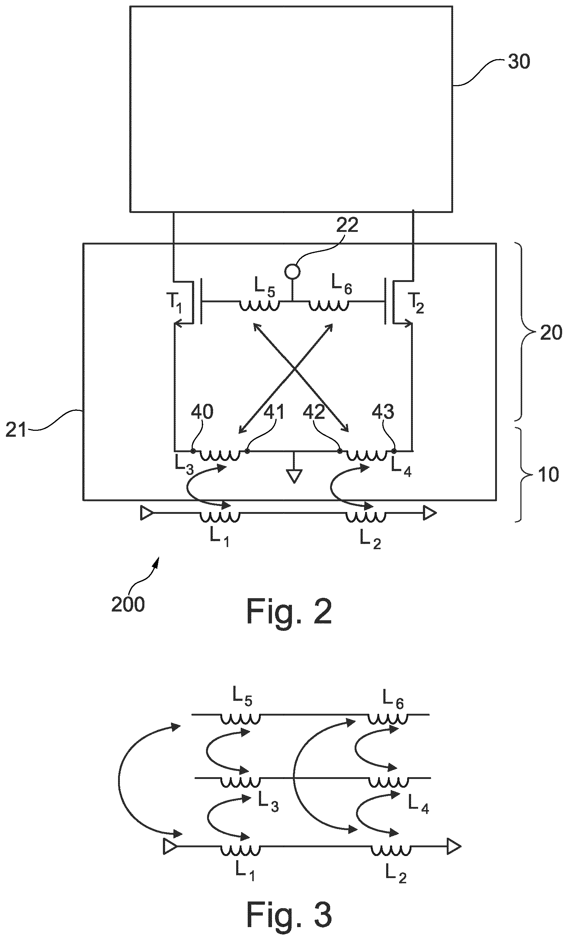

FIG. 2 shows a noise cancellation common gate low-noise amplifier 200 using cross-coupled inductors in contrast to the cross-coupled capacitors as in the conventional amplifier structure of FIG. 1. Similar to the conventional structure of FIG. 1, the balun device 10 comprises a primary coil implemented as a first inductor system with first and second inductors L1, L2, respectively. A second coil is implemented as a second inductor system with third and fourth inductors L3 and L4, respectively, the secondary coil being connected to the ground by means of a mid-point tap. Furthermore, a third inductor system comprises fifth and sixth inductors L5, L6, respectively, the third inductor system having a mid-point tap at input node 22.

A cross-coupled connection between the second inductor system having inductors L3, L4 and the third inductor system having inductors L5 and L6 is provided in the following way: As shown, a first connection point 40 of the third inductor L3 is galvanically connected to a source of the first transistor T1. Furthermore, a second connection point 43 of the fourth inductor L4 is galvanically connected to a source of the second transistor T2. Furthermore, a second connection point 41 of the third inductor L3 and a first connection point 42 of the fourth inductor L4 are galvanically connected, said galvanic connection having a tapping to ground.

Thus, noise from the source of the first transistor T1 may be copied to the gate of the second transistor T2 and noise from the second transistor T2 may be copied to the gate of the first transistor T1. Hence, the noise at the sources of the transistors T1 and T2 is connected to the gates of said transistors T1, T2, resulting in a noise cancellation effect.

In more detail, noise signals of the first transistor T1 and the second transistor T2 seen at output nodes 31, 32 (not shown in FIG. 2) of the cascode device 30 have the same polarity and may cancel each other, thus improving a noise cancellation effect. By means of the cross-coupled inductors L4, L5 and L3, L6, respectively, a signal from the source of the first transistor T1 gets copied to the gate of the second transistor T2. In this way, it is achieved that noise of a relation of transistors T1/T2 seen at the outputs 31, 32 (not shown in FIG. 2) of the cascode device 30 has the same polarity and thus cancel each other.

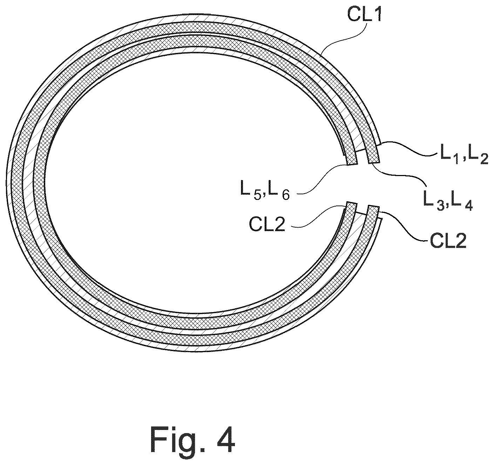

The inductances L3, L4 of the second inductor system and the inductances L5, L6 of the third inductor system can be realized by a single conductive layer, as described in more detail referring to FIG. 4. Hence, the inductors L3-L6 can be realized with little effort. Hence, the disclosed noise-cancellation amplifier can be built easily and effectively with reduced on-chip area (integrated circuit) and simplified layout. The simplified layout results from the fact, that only a single type of components is used for the noise cancellation structure 21, namely inductors, compared to the conventional case which need integrated resistors R1, R2 together with integrated capacitors C1, C2. The conventional resistors R1, R2 and capacitors C1, C2 have to be integrated which is omitted in the disclosed amplifier, with the result of saving of chip area.

At least one of the transistors T1, T2, preferably both transistors T1, T2 are Field Effect Transistors (FETs). Also other types of transistors (e.g. bipolar transistors) are possible.

FIG. 3 shows magnetic couplings of all inductors involved. In particular, FIG. 3 shows direct inductive couplings between the inductors L1-L6 of the three inductor systems. Due to the placement near to each other of the inductors L1-L6 they have the shown coupling indicated with curved double arrows. Shown is a direct inductive coupling between the inductors L1, L2 and the inductors L3, L4, a direct inductive coupling between the inductors L3, L4 and the inductors L5, L6, and a direct inductive coupling between the inductors L1, L2, and the inductors L5, L6. The cross-coupling of the second and third inductor systems is not shown in FIG. 3.

A coupling coefficient k between the second inductor system (inductors L3, L4) and the third inductor system (inductors L5, L6) is a ratio of the open-circuit actual voltage ratio to the ratio that would be obtained if all the flux coupled from one magnetic circuit to the other. The coupling coefficient is related to mutual inductance and self-inductances. The coupling coefficient is a usual way to specify the relationship between a certain orientation of inductors with arbitrary inductance, wherein a range can be specified as 0 <= k < 1. Allowing negative values of k captures phase inversions of the coil connections and the direction of the windings.

FIG. 4 is a top plan view of implementing the three inductors systems as mentioned before. Shown are two conductive layers, a first conductive layer CL1 and a second conductive layer CL2, which implement the three inductor systems. The conductive layers CL1 and CL2 are preferably metal layers. In more detail, the first conductive layer CL1 is used to realize the first inductor system having the inductors L1, L2. Furthermore, the second conductive layer CL2 is used to realize both the second inductor system (inductors L3, L4) and the third inductor system (inductors L5, L6). The two conductive layers CL1, CL2 are made recognizable by different hatchings in FIG. 4.

A split of a conductive layer CL2 in order to realize the inductors L3, L4 of the second inductor system, and the inductors L5, L6 of the third inductor system may be designed appropriately by designing the conductive layer CL2. For example, a specific design of the conductive layer CL2 (e.g. with respect to length/width of conductor tracks, connection points of the inductors for connecting to the gates and sources of the transistors T1, T2, etc.) is performed to use the second conductive layer CL2 for an implementation of the second and third inductor systems.

Moreover, no electric signals are lost by the appropriate splitting of the second conductive layer CL2 into the second and third inductor systems. Furthermore, the coupling of the inductors L3, L4 of the second inductor system with the inductors L5, L6 of the third inductor system determines the cross-coupling effect. In this way, the inductive coupling can be adjusted without affecting the space requirements of the inductors L3-L6.

Implementation of the first inductor system providing the primary inductors L1, L2 is done by means of a first conductive layer CL1. In this way, windings of two conductive layers CL1, CL2 are used to implement the three mentioned inductor systems having inductors L1-L6. This means that an improved implementation and reduced chip area because no space is necessary for additional resistors and capacitors compared to the conventional noise cancellation structure 21 of FIG. 1.

Summarizing, to realize the noise cancellation structure 21 inductors L3, L4, L5, L6 are used instead of cross-coupled capacitors C1, C2 and resistors R1, R2 for the functional coupling of the two transistors T1, T2. As a result, as compared to a known capacitive approach, a similar noise cancellation effect can be obtained with the noise cancellation structure 21 of FIG. 2, however with a much easier technical implementation than the conventional noise cancellation structure 21 of FIG. 1. The second conductive layer CL2 in this way is used to realize the second inductor system and the third inductor system.

In this way, a split of the second conductive layer CL2 is carried out in order to implement the two inductor systems. The mentioned splitting of the secondary coil of the balun device 10 requires no structural change to the per se known balun structure. In this way, by appropriately connecting the second conductive layer CL2, a signal from the source of the second transistor T2 gets automatically copied to the gate of the first transistor T1 by means of the "cross-coupled" inductors L3, L6 and L4, L5, respectively of the second inductor system and third inductor system, respectively. In FIG. 2, the cross-coupling is emphasized by a double arrow between the fourth inductor L4 of the second inductor system with the fifth inductor L5 of the third inductor system and a double arrow between the third inductor L3 of the second inductor system and the sixth inductor L6 of the third inductor system.

No additional capacitors and resistors are needed compared to the conventional noise cancellation structure 21 (shown in FIG. 1). The layout with the two conductive layers CL1, CL2 is simple, and there is less process variation and fewer components because no resistors and capacitors are needed to implement the conventional noise cancellation structure 21 of FIG. 1.

The proposed use of inductors advantageously increases integration possibilities, because inductors are simpler to integrate and also enable a further integration of balun design. Inductors introduced for noise cancellation are integrated in a design with the balun used to create differential outputs from a single RF input. Also, efforts for simulation in a design process of the proposed LNA may be reduced.

The disclosed noise-cancellation low-noise amplifier 200 can e.g. be used for wireless radios as it is required by other RF blocks, i.e. components or sections of a system that deal with radio frequency (RF) signals, such as voltage-controlled oscillators (VCOs), power amplifiers, etc. In an implementation, cross-coupled inductor simplicity will result in better performance and reduced performance dependency on the layout.

The proposed noise-cancellation low-noise amplifier may be used for any wireless connectivity application, including e.g. UWB, Wireless Fidelity (Wi-Fi), Bluetooth (BT), cell phones, and all kinds of receivers with differential cascaded gain low-noise amplifiers (CG LNA).

As another example, where the specification may make reference to a "first" type of structure, a "second" type of structure, where the adjectives "first" and "second" are not used to connote any description of the structure or to provide any substantive meaning; rather, such adjectives are merely used for English-language antecedence to differentiate one such similarly-named structure from another similarly-named structure.

Based upon the above discussion and illustrations, those skilled in the art will readily recognize, that various modifications and changes may be made to the various embodiments without strictly following the exemplary embodiments and applications illustrated and described herein. For example, methods as exemplified in the Figures may involve steps carried out in various orders, with one or more aspects of the embodiments herein retained, or may involve fewer or more steps.

It should be noted that the term "comprising" does not exclude other elements or steps and "a" or "an" does not exclude a plurality. Also elements described in association with different embodiments may be combined. It should also be noted, that reference signs in the claims should not be construed as limiting the scope of the claims.

### Reference signs:

- 10: balun device
- 20: connection stage
- 21: noise cancellation structure
- 22: input node
- 30: cascode device
- 31, 32: output nodes
- 33: input
- 40: 1st connection point third inductor
- 41: 2^{nd} connection point third inductor
- 42: 1st connection point fourth inductor
- 43: 2^{nd} connection point fourthinductor
- 100: noise-cancellation amplifier
- 200: noise-cancellation amplifier
- k: coupling factor
- L1: 1^{st} inductor
- L2: 2^{nd} inductor
- L3: 3^{rd} inductor
- L4: 4^{th} inductor
- L5: 5^{th} inductor
- L6: 6^{th} inductor
- CL1: 1^{st} conductive layer
- CL2: 2^{nd} conductive layer
- T1: 1^{st} transistor
- T2: 2^{nd} transistor

## Claims

1. A noise-cancellation amplifier (200), comprising
a first inductor system with a first inductor (L1) and a second inductor (L2);
a second inductor system with a third inductor (L3) and a fourth inductor (L4);
a first transistor (T1) being coupled with the third inductor (L3);
a second transistor (T2) being coupled with the fourth inductor (L4); and
a third inductor system with a fifth inductor (L5) and a sixth inductor (L6), the fifth inductor (L5) being coupled with a gate of the first transistor (T1) and the sixth inductor (L6) being coupled with a gate of the second transistor (T2); wherein
the first inductor system is inductively coupled with the second inductor system and the second inductor system is inductively coupled with the third inductor system.

2. The noise-cancellation amplifier (200) according to claim 1, wherein the third inductor (L3) is inductively coupled with the sixth inductor (L6).

3. The noise-cancellation amplifier (200) according to claim 1 or 2, wherein the fourth inductor (L4) is inductively coupled with the fifth inductor (L5).

4. The noise-cancellation amplifier (200) according to any of the preceding claims, wherein a coupling factor (k) between the second inductor system and the third inductor system is at least 0.7.

5. The noise-cancellation amplifier (200) according to any of the preceding claims, wherein the fifth inductor (L5) is connected in series with the sixth inductor (L6), wherein an input node (22) is formed between the fifth inductor (L5) and the sixth inductor (L6).

6. The noise-cancellation amplifier (200) according to claim 5, wherein the input node (22) is configured to receive a biasing signal for the transistors (T1, T2).

7. The noise-cancellation amplifier (200) according to any of the preceding claims, wherein the third inductor (L3) is connected in series with the fourth inductor (L4) through a second connection point (41) of the third inductor (L3) and a first connection point (42) of the fourth inductor (L4), wherein the first connection point (42) of the fourth inductor (L4) and the second connection point (41) of the third inductor (L3) are connected to ground.

8. The noise-cancellation amplifier (200) according to any of the preceding claims, wherein the first inductor (L1) and the second inductor (L2) are connected in series.

9. The noise-cancellation amplifier (200) according to any of the preceding claims, wherein a first connection point (40) of the third inductor (L3) is coupled to a source of the first transistor (T1) and wherein a second connection point (43) of the fourth inductor (L4) is coupled to a source of the second transistor (T2).

10. The noise-cancellation amplifier (200) according to any of the preceding claims, further comprising a cascode device (30), wherein drains of the first and second transistors (T1, T2) are coupled to the cascode device (30).

11. The noise-cancellation amplifier (200) according to any of the preceding claims, wherein the first inductor (L1) is inductively coupled to the third inductor (L3) and the sixth inductor (L6).

12. The noise-cancellation amplifier (200) according to any of the preceding claims, wherein the second inductor (L2) is inductively coupled to the fourth inductor (L4) and the fifth inductor (L5).

13. The noise-cancellation amplifier (200) according to any of the preceding claims, wherein the first inductor (L1) and the second inductor (L2) are made of a first conductive layer (CL1) and wherein the third inductor (L3), the fourth inductor (L4), the fifth inductor (L5), and the sixth inductor (L6) are made of a second conductive layer (CL2).

14. The noise-cancellation amplifier (200) according to claim 13, wherein at least one of the first conductive layer (CL1) and the second conductive layers (CL2) is a metal layer.

## Amended claims

### Amended claims in accordance with Rule 137(2) EPC.

1. A noise-cancellation amplifier (200), comprising
a first inductor system with a first inductor (L1) and a second inductor (L2);
a second inductor system with a third inductor (L3) and a fourth inductor (L4);
a first transistor (T1) being coupled with the third inductor (L3);
a second transistor (T2) being coupled with the fourth inductor (L4); and
a third inductor system with a fifth inductor (L5) and a sixth inductor (L6), the fifth inductor (L5) being coupled with a gate of the first transistor (T1) and the sixth inductor (L6) being coupled with a gate of the second transistor (T2); wherein
the first inductor system is inductively coupled with the second inductor system and the second inductor system is inductively coupled with the third inductor system; wherein the third inductor (L3) is inductively coupled with the sixth inductor (L6); and wherein the fourth inductor (L4) is inductively coupled with the fifth inductor (L5).

2. The noise-cancellation amplifier (200) according to claim 1, wherein a coupling factor (k) between the second inductor system and the third inductor system is at least 0.7.

3. The noise-cancellation amplifier (200) according to claim 1 or 2, wherein the fifth inductor (L5) is connected in series with the sixth inductor (L6), wherein an input node (22) is formed between the fifth inductor (L5) and the sixth inductor (L6).

4. The noise-cancellation amplifier (200) according to claim 3, wherein the input node (22) is configured to receive a biasing signal for the transistors (T1, T2).

5. The noise-cancellation amplifier (200) according to any of the preceding claims, wherein the third inductor (L3) is connected in series with the fourth inductor (L4) through a second connection point (41) of the third inductor (L3) and a first connection point (42) of the fourth inductor (L4), wherein the first connection point (42) of the fourth inductor (L4) and the second connection point (41) of the third inductor (L3) are connected to ground.

6. The noise-cancellation amplifier (200) according to any of the preceding claims, wherein the first inductor (L1) and the second inductor (L2) are connected in series.

7. The noise-cancellation amplifier (200) according to any of the preceding claims, wherein a first connection point (40) of the third inductor (L3) is coupled to a source of the first transistor (T1) and wherein a second connection point (43) of the fourth inductor (L4) is coupled to a source of the second transistor (T2).

8. The noise-cancellation amplifier (200) according to any of the preceding claims, further comprising a cascode device (30), wherein drains of the first and second transistors (T1, T2) are coupled to the cascode device (30).

9. The noise-cancellation amplifier (200) according to any of the preceding claims, wherein the first inductor (L1) is inductively coupled to the third inductor (L3) and the sixth inductor (L6).

10. The noise-cancellation amplifier (200) according to any of the preceding claims, wherein the second inductor (L2) is inductively coupled to the fourth inductor (L4) and the fifth inductor (L5).

11. The noise-cancellation amplifier (200) according to any of the preceding claims, wherein the first inductor (L1) and the second inductor (L2) are made of a first conductive layer (CL1) and wherein the third inductor (L3), the fourth inductor (L4), the fifth inductor (L5), and the sixth inductor (L6) are made of a second conductive layer (CL2).

12. The noise-cancellation amplifier (200) according to claim 11, wherein at least one of the first conductive layer (CL1) and the second conductive layers (CL2) is a metal layer.
